# EUROPÄISCHE PATENTSCHRIFT

(11) **EP 2 636 080 B1**
(45) Veröffentlichungstag und Bekanntmachung des Hinweises auf die Patenterteilung: **29.11.2017**
(21) Anmeldenummer: 11773229.7
(22) Anmeldetag: 14.10.2011
(51) Int. Cl.: H01L 35/32, F02G 5/00

(54) **THERMOELEKTRISCHES MODUL FÜR EINEN THERMOELEKTRISCHEN GENERATOR EINES FAHRZEUGS**
THERMOELECTRIC MODULE FOR A THERMOELECTRIC GENERATOR OF A VEHICLE
MODULE THERMOÉLECTRIQUE POUR UN GÉNÉRATEUR THERMOÉLECTRIQUE D'UN VÉHICULE

(30) Priorität: 03.11.2010 DE 102010050395
(43) Veröffentlichungstag der Anmeldung: 11.09.2013
(73) Patentinhaber: Continental Automotive GmbH, 30165 Hannover (DE); Bayerische Motoren Werke Aktiengesellschaft, 80809 München (DE)
(72) Erfinder: EDER, Andreas, 80339 München (DE); NEUGEBAUER, Stephan, 82441 Ohlstadt (DE); LINDE, Matthias, 85540 Haar (DE); LIMBECK, Sigrid, 53804 Much (DE); BRÜCK, Rolf, 51429 Bergisch Gladbach (DE)
(74) Vertreter: Rössler, Matthias
(86) Internationale Anmeldenummer: PCT/EP2011/067952
(87) Internationale Veröffentlichungsnummer: WO 2012/059309

(56) Entgegenhaltungen:
- DE-A1-102006 039 024
- FR-A1- 2 732 819
- US-A- 3 211 586
- US-A1- 2003 140 957

## Beschreibung

Die vorliegende Erfindung betrifft ein thermoelektrisches Modul, insbesondere für den Einsatz in einem thermoelektrischen Generator, der in einem Fahrzeug zum Einsatz kommt.

Das Abgas aus einer Verbrennungskraftmaschine eines Kraftfahrzeugs besitzt thermische Energie, welche mittels eines thermoelektrischen Generators in elektrische Energie umgewandelt werden kann, bspw. um eine Batterie oder einen anderen Energiespeicher zu füllen und/oder elektrischen Verbrauchern die benötigte Energie direkt zuzuführen. Damit wird das Kraftfahrzeug mit einem besseren energetischen Wirkungsgrad betrieben, und es steht für den Betrieb des Kraftfahrzeugs Energie in größerem Umfang zur Verfügung.

Ein solcher thermoelektrischer Generator weist zumindest ein thermoelektrisches Modul auf. Thermoelektrische Module umfassen z. B. wenigstens zwei Halbleiterelemente (p- und n-dotiert), die auf ihrer Ober- und Unterseite (hin zur Heißseite bzw. Kaltseite) wechselseitig mit elektrisch leitenden Brücken versehen sind und die die kleinste thermoelektrische Einheit bzw. ein thermoelektrisches Element bilden. Thermoelektrische Materialien sind von einer Art, dass diese thermische Energie in elektrische Energie umwandeln können (Seebeck-Effekt) und umgekehrt (Peltier-Effekt). Wird ein Temperaturgefälle beidseits der Halbleiterelemente bereitgestellt, so bildet sich zwischen den Enden der Halbleiterelemente ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind bevorzugt zahlreiche Halbleiterelemente elektrisch in Reihe geschaltet. Damit sich die generierten Potentialdifferenzen der seriellen Halbleiterelemente nicht gegenseitig aufheben, sind stets wechselweise Halbleiterelemente mit unterschiedlichen Majoritätsladungsträgern (n- und p-dotiert) in direkten elektrischen Kontakt gebracht. Mittels eines angeschlossenen Lastwiderstands kann der Stromkreis geschlossen und somit elektrische Leistung abgegriffen werden.

Um eine dauerhafte Einsatzfähigkeit der Halbleiterelemente zu gewährleisten, wird zwischen den elektrisch leitenden Brücken und dem thermoelektrischen Material regelmäßig eine Diffusionsbarriere angeordnet, die ein Diffundieren von in den elektrischen Brücken bzw. im Lot enthaltenem Material in das thermoelektrische Material verhindert und damit einem Effektivitätsverlust bzw. ein funktionelles Versagen des Halbleitermaterials bzw. des thermoelektrischen Elements verhindert. Der Aufbau von thermoelektrischen Modulen bzw. der Halbleiterelemente erfolgt üblicherweise durch den Zusammenbau der einzelnen Komponenten thermoelektrisches Material, Diffusionsbarriere, elektrisch leitende Brücken, Isolierung und ggf. weiteren Gehäuseelementen zu einem thermoelektrischen Modul, das von einem heißen bzw. kalten Medium überströmt wird. Dieser Zusammenbau zahlreicher einzelner Komponenten erfordert auch eine genaue Abstimmung der einzelnen Bauteiltoleranzen und eine Berücksichtigung der Wärmeübergänge von der Heißseite zur Kaltseite sowie der hinreichenden Kontaktierung der elektrisch leitenden Brücken, so dass ein Stromfluss durch das thermoelektrische Modul erzeugt werden kann.

Für die Anordnung solcher Halbleiterelemente in einem thermoelektrischen Modul sind regelmäßige Gehäuse, Wände und/oder Stützrohre zur äußeren Begrenzung des Moduls vorgesehen, an denen die Halbleiterelemente befestigt sind. Dies führt insbesondere dazu, dass bei der Fertigung hohe Toleranzanforderungen gegeben sind, um einerseits eine passgenaue Anordnung der Halbleiterelemente mit Bezug auf die elektrischen Verbindungen sowie die Position der Gehäuse zu realisieren. Problematisch ist darüber hinaus, dass infolge der unterschiedlichen thermischen Belastungen der äußeren und inneren Gehäuseteile auch unterschiedliche Ausdehnungsverhalten dieser Komponenten kompensiert werden müssen, ohne dass besonders hohe Spannungen in das thermoelektrische Material eingeleitet werden. Gerade im Hinblick auf eine solche Fertigung von thermoelektrischen Modulen ist gewünscht, die Vielzahl von Bauteilen leicht miteinander kombinieren zu können, die Lagerung und die Handhabung zu vereinfachen und auch beim Zusammenbau eine leichte, stabile Struktur zu erzeugen.

Aus der US-A1-2003/140957 ist ein thermoelektrisches Modul bekannt, bei dem zylindrische thermoelektrische Elemente nebeneinander an ringförmigen Rahmenteilen angeordnet sind. Die Rahmenteile sind entlang der axialen Richtung hintereinander angeordnet und erstrecken sich wechselweise jeweils zur Heißseite und zur Kaltseite. Die Rahmenteile bilden zum Teil eine unterbrochene Umfangsfläche. Rohrförmige Gehäuse umschließen die Rahmenteile und trennen den Innenraum des thermoelektrischen Moduls von der von einem Fluid durchströmten Heiß- bzw. Kaltseite.

Hiervon ausgehend ist es Aufgabe der vorliegenden Erfindung, die mit Bezug auf den Stand der Technik geschilderten Probleme zumindest teilweise zu lösen. Insbesondere soll ein thermoelektrisches Modul angegeben werden, das technisch einfach herstellbar ist, eine reduzierte Teilezahl aufweist, für den gewünschten Einsatz stabil ist und/oder zudem einen hohen Wirkungsgrad aufweist, um der thermischen Energie eines Abgases elektrische Energie zu erzeugen.

Diese Aufgaben werden gelöst mit einem thermoelektrischen Modul gemäß den Merkmalen des Patentanspruchs 1. Weitere vorteilhafte Ausgestaltungen der Erfindung sind in den abhängig formulierten Patentansprüchen angegeben. Die in den Patentansprüchen einzeln aufgeführten Merkmale sind in beliebiger, technologisch sinnvoller, Weise miteinander kombinierbar und zeigen weitere Ausgestaltungen der Erfindung auf. Die Beschreibung, insbesondere im Zusammenhang mit den Figuren, erläutert die Erfindung weiter und führt ergänzende Ausführungsbeispiele der Erfindung an.

Das erfindungsgemäße thermoelektrische Modul weist eine Innenumfangsfläche, eine Achse und eine Außenumfangsfläche auf, wobei in Richtung der Achse und zwischen der Innenumfangsfläche und der Außenumfangsfläche eine Mehrzahl von Halbleiterelementen mit thermoelektrischem Material angeordnet und elektrisch miteinander wechselweise verbunden sind. Zudem weist wenigstens ein Teil der Halbleiterelemente zumindest ein inneres Rahmenteil oder ein äußeres Rahmenteil auf. Weiter bilden zumindest innere Rahmenteile eine unterbrochene Innenumfangsfläche oder äußere Rahmenteile eine unterbrochene Außenumfangsfläche.

Das thermoelektrische Modul stellt insbesondere eine separate Baueinheit eines thermoelektrischen Generators dar. Bevorzugt ist dabei, dass das thermoelektrische Modul einen Anschluss aufweist, mit dem ein solches thermoelektrisches Modul ggf. mit einer Vielzahl weiterer thermoelektrischer Module elektrisch verschaltet werden kann. Innerhalb des thermoelektrischen Moduls ist also insbesondere die elektrische Verbindung bzw. Verschaltung aller dort integrierten Halbleiterelemente realisiert. Ein solches thermoelektrisches Modul wird nun einerseits einem Kühlmedium und andererseits einem Heißmedium ausgesetzt. Hierbei steht insbesondere im Fokus, dass das thermoelektrische Modul über seine Außenumfangsfläche mit einem Kühlmedium und über seine Innenumfangsfläche mit einem Heißmedium (insbesondere Abgas) in Kontakt gebracht wird bzw. von diesen Medien durchströmt/umströmt wird. Damit bildet praktisch die Innenumfangsfläche eine sogenannte Heißseite und die Außenumfangsfläche eine sogenannte Kaltseite des thermoelektrischen Moduls aus.

Weiterhin ist bevorzugt, dass das thermoelektrische Modul länglich ausgeführt ist, also bspw. nach Art einer Schiene oder eines Rohrs. Auch wenn ganz besonders bevorzugt ist, dass das thermoelektrische Modul in etwa wie ein Zylinder bzw. ein Rohr gestaltet ist, ist eine solche Form nicht zwingend. Insbesondere können auch ovale Querschnitte oder polygonale Querschnitte für ein solches thermoelektrisches Modul in Betracht gezogen werden. Entsprechend dieser Gestalt lässt sich nun auch eine zentrale Achse sowie eine Innenumfangsfläche und eine Außenumfangsfläche identifizieren. Die Innenumfangsfläche begrenzt dabei insbesondere einen inneren Kanal, durch den das Heißmedium (Abgas) hindurchströmen kann.

Zwischen dieser Innenumfangsfläche und der Außenumfangsfläche sind die thermoelektrischen Materialien positioniert, wobei diese jeweils sogenannten Halbleiterelementen zugeordnet sind. Eine Vielzahl solcher Halbleiterelemente können in Richtung der Achse aufeinander gestapelt angeordnet sein, insbesondere nach der Art, dass abwechselnd ein Halbleiterelement mit p-dotiertem thermoelektrischen Material und ein Halbleiterelement mit n-dotiertem thermoelektrischen Material benachbart zueinander angeordnet sind. Insofern ist ganz besonders bevorzugt, dass sich das Halbleiterelement einer vorgegebenen Dotierung vollständig um die Innenumfangsfläche herum erstreckt, bspw. nach Art von Scheiben oder Ringen. Dieses thermoelektrische Material ist nun eingefasst von einem inneren Rahmenteil und/oder einem äußeren Rahmenteil. Bevorzugt ist, dass das Halbleiterelement jeweils ein inneres Rahmenteil sowie ein äußeren Rahmenteil aufweist, die innen und außen jeweils das thermoelektrische Material vollständig umschließen. Entsprechend der Form des Halbleiterelements sind die Rahmenteile bspw. nach Art von Ringen bzw. Zylindern ausgeführt.

Besonders bevorzugt ist, dass das thermoelektrische Material mit den Rahmenteilen kraftschlüssig verbunden (verpresst) ist. "Kraftschlüssige Verbindungen" entstehen durch die Übertragung von Kräften. Dazu zählen z. B. Druckkräfte und/oder Reibungskräfte. Der Zusammenhalt der kraftschlüssigen Verbindung wird rein durch die wirkende Kraft gewährleistet.

Weiterhin ist bevorzugt, dass die Rahmenteile gleichzeitig eine Diffusionsbarriere für das thermoelektrische Material sowie einen elektrischen Stromleiter ausbilden. Als Material für die Rahmenteile werden Nickel oder Molybdän bevorzugt, wobei diese jeweils ganz besonders bevorzugt mit zumindest 95 Massenprozent im Werkstoff der Rahmenteile vorhanden sind. Als thermoelektrisches Material werden insbesondere die folgenden Werkstoffe als geeignet angesehen:
n-Typ: Bi₂Te₃; PbTe; Ba_{0.3}Co_{3,95}Ni_{0,05}Sb₁₂; Ba_{y}(Co,Ni)₄Sb₁₂; CoSb₃; Ba₈Ga₁₆Ge₃₀; La₂Te₃; SiGe; Mg₂(Si,Sn);
p-Typ: (Bi,Sb)₂TE₃; Zn₄Sb₃; TAGS; PbTe; SnTe; CeFe₄Sb₁₂; Yb₁₄MnSb₁₁; SiGe; Mg₂(Si,Sb).

Die thermoelektrischen Materialien bzw. die Halbleiterelemente sind nun elektrisch miteinander wechselweise verbunden, so dass sich aufgrund der Temperaturdifferenz zwischen der Innenumfangsfläche und der Außenumfangsfläche ein Stromfluss durch das thermoelektrische Modul und die thermoelektrischen Materialien hindurch ausbildet. Die elektrische Verbindung kann über eine metallische Brücke, ein Kabel, Lotmaterial oder dergleichen realisiert sein. Wie bereits ausgeführt, ist die elektrische Verbindung bevorzugt (nur) mittels des Rahmenteils realisiert.

Bei der erfindungsgemäßen Ausgestaltung des thermoelektrischen Moduls bilden nun die inneren Rahmenteile keine geschlossene Innenumfangsfläche und/oder die äußeren Rahmenteile keine geschlossene Außenumfangsfläche. Damit wird insbesondere zum Ausdruck gebracht, dass die Innenumfangsfläche und/oder die Außenumfangsfläche nicht nach Art geschlossener Gehäusewandung ausgeführt ist, sondern hier Unterbrechungen vorgesehen sind. Für den Fall, dass das thermoelektrische Modul bspw. nach Art eines Rohrs ausgebildet ist, wären eine zylindrische Innenumfangsfläche und/oder eine zylindrische Außenumfangsfläche gegeben. Mit den inneren Rahmenteilen wird nun aber nur ein Teil der zylindrischen Innenumfangsfläche gebildet, so dass ein Teil dieser (gedachten) zylindrischen Innenumfangsfläche frei bzw. unterbrochen ist. Dies gilt entsprechend für eine (gedachte) zylindrische Außenumfangsfläche, die ebenfalls nicht vollständig von den äußeren Rahmenteilen abgebildet wird. Auch wenn das hier für ein rohrähnliches thermoelektrisches Modul veranschaulicht ist, so lässt sich diese Betrachtung entsprechend auf andere Querschnittsformen des thermoelektrischen Moduls sinngemäß übertragen. Diese Unterbrechungen in der Außenumfangsfläche ermöglichen bspw., dass die inneren Rahmenteile von außen auch nach dem Zusammensetzen der Halbleiterelemente für Montage- und/oder Fügeschritte erreichbar sind. Ein weiterer Grund für die hier vorgeschlagenen Unterbrechungen ist, dass das thermoelektrische Modul bzw. die gestapelte und/oder gefügte Anordnung der Halbleiterelemente im Bereich der Außenumfangsfläche bzw. der Innenumfangsfläche in Richtung der Achse nicht starr ist, sondern die Unterbrechungen genutzt werden können, um thermische Dehnungen und/oder Fertigungstoleranzen zu kompensieren. Wird zudem mit jedem (zentral angeordneten) Halbleiterelement ein Verbindungsbereich hin zum benachbarten Halbleiterelement sowohl im Bereich der Innenumfangsfläche als auch im Bereich der Außenumfangsfläche ausgebildet (also bspw. an einer Stirnseite über das äußere Rahmenteil und an der anderen Stirnseite über das innere Rahmenteil), kann eine formstabile Konstruktion eines thermoelektrischen Moduls geschaffen werden, ohne dass es hierzu eines weiteren Gehäuses zur Stabilisierung bzw. Abstützung dieser Anordnung bedarf. Insbesondere kann auf ein zusätzliches inneres Mantelrohr und/oder ein äußeres Mantelrohr verzichtet werden. Hieraus kann sofort erkannt werden, dass diese Anordnung von Halbleiterelementen bzw. die Ausprägung und Verbindung der jeweiligen Rahmenteile technisch einfach durchgeführt werden kann. Zudem kann so eine robuste und für weitere Bearbeitungsschritte sowie den nachfolgenden Einsatz im thermoelektrischen Generator robuste Anordnung geschaffen werden.

Gemäß einer Weiterbildung des thermoelektrischen Moduls wird vorgeschlagen, dass Halbleiterelemente thermoelektrisches Material umfassen, das zwischen einem inneren Rahmenteil und einem äußeren Rahmenteil angeordnet ist, wobei das innere Rahmenteil und das äußere Rahmenteil jeweils einseitig über das thermoelektrische Material überstehen und dort einen formsteifen Verbindungsbereich mit einem benachbarten Rahmenteil bilden. Ganz besonders bevorzugt ist in diesem Zusammenhang, dass alle Halbleiterelemente des thermoelektrischen Moduls (mit Ausnahme der Halbleiterelemente am Anfang und am Ende) entsprechende Verbindungsbereiche mit benachbarten Rahmenteilen bilden. Ganz besonders bevorzugt sind dabei stets äußere Rahmenteile mit äußeren Rahmenteilen und innere Rahmenteile mit inneren Rahmenteilen verbunden. Insofern ist es vorteilhaft, wenn die inneren Rahmenteile und die äußeren Rahmenteile bei einem einzelnen Halbleiterelement in verschiedene Richtungen parallel zur Achse überstehen. Hierbei ist möglich, dass dabei jedes Rahmenteil nur hinsichtlich einer Seite des thermoelektrischen Materials übersteht. Bevorzugt ist jedoch, dass zu beiden Seiten des thermoelektrischen Materials jeweils einmal das innere Rahmenteil und einmal das äußere Rahmenteil am weitesten hervorstehen. Ein solcher formsteifer Verbindungsbereich kann bspw. mit einer Lotverbindung, einer Klebeverbindung oder einer Schweißverbindung realisiert sein. Die Verbindungsbereiche sind nun insbesondere so ausgelegt, dass diese die im Betrieb eines thermoelektrischen Generators im Fahrzeug auftretenden statischen, dynamischen und thermischen Kräfte in Richtung der Achse und/oder radial dazu aufnehmen können. Hierfür ist ganz besonders bevorzugt, dass der Verbindungsbereich sich jeweils über den gesamten Umfang der Rahmenteile erstreckt, bspw. als umlaufende Schweißnaht zwischen benachbarten äußeren Rahmenteilen sowie zwischen benachbarten inneren Rahmenteilen. Diese Verbindungsbereiche gewährleisten nun insbesondere, dass das thermoelektrische Modul formsteif bzw. stabil ist, so dass eine unverlierbare Anordnung der Mehrzahl von Halbleiterelementen gegeben ist. Bei einem solchen thermoelektrischen Modul werden dabei insbesondere mehr als 10, insbesondere mehr als 30 und bevorzugt mehr als 50 solcher Halbleiterelemente gestapelt und wechselseitig mit Verbindungsbereichen ausgeführt. Auch bei solch großen, länglichen thermoelektrischen Modulen kann auf eine stabilisierende zusätzliche Innenwand und/oder zusätzliche Außenwand verzichtet werden, wodurch insbesondere der Fertigungsaufwand reduziert und der Materialaufwand vermindert werden kann.

Einer bevorzugten Ausgestaltung des thermoelektrische Moduls folgend weist zumindest das innere Rahmenteil oder das äußere Rahmenteil eine Isolationsschicht auf. Diese Isolationsschicht kann bereichsweise und/oder vollständig auf der Oberfläche des inneren Rahmenteils und/oder des äußeren Rahmenteils vorgesehen sein, und dient insbesondere zur elektrischen Isolation der Strompfade. Hierfür kommt insbesondere eine Isolationsschicht umfassend Aluminiumoxid (Al₂O₃) oder dergleichen in Betracht.

Darüber hinaus wird als vorteilhaft angesehen, dass in der unterbrochenen Außenumfangsfläche ein Freiraum zwischen benachbarten äußeren Rahmenteilen gebildet ist, der einem Abstand des thermoelektrischen Materials benachbarter Halbleiterelemente entspricht. Hiermit wird insbesondere auch zum Ausdruck gebracht, dass die Anordnung der Halbleiterelemente mit den äußeren Rahmenteilen so erfolgt, dass im Bereich der Unterbrechung der Außenumfangsfläche ein möglichst großer Freiraum geschaffen ist und dieser Freiraum insbesondere nicht durch überstehende Bereiche der äußeren Rahmenteile eingeschränkt ist. Dies ermöglicht insbesondere, dass der maximal verfügbare Freiraum hier genutzt werden kann, um bspw. die Verbindungsbereiche an den inneren Rahmenteilen in diesen Freiraum von außen zu verwirklichen. So kann insbesondere mittels einer Schweißvorrichtung durch diesen relativ großen Freiraum eine Schweißnaht zwischen den innen liegenden inneren Rahmenteilen verwirklicht werden. Dies wird insbesondere dadurch erreicht, dass die äußeren Rahmenteile bündig mit einer Seitenfläche des thermoelektrischen Materials abschließen. Damit sind die benachbarten äußeren Rahmenteile nun so weit voneinander entfernt, wie der Abstand der Oberseite bzw. Unterseite der benachbarten thermoelektrischen Materialien. Im zusammengebauten Zustand wird häufig ein in Umfangsrichtung umlaufender Freiraum gebildet, der definiert wird durch die radial außen liegende Umfangsfläche der benachbarten inneren Rahmenteile, der sich gegenüberliegenden Oberseite und Unterseite der benachbarten thermoelektrischen Materialien sowie der zugeordneten Unterbrechung der Außenumfangsfläche. Für den Fall, dass ein zylindrisches, rohrförmiges thermoelektrisches Modul vorgegeben ist, hat der Freiraum folglich im Wesentlichen die Form eines Rings, der konzentrisch zur Achse angeordnet ist und sich zwischen benachbarten thermoelektrischen Materialien erstreckt.

Gemäß einer Weiterbildung ist zumindest in der unterbrochenen Außenumfangsfläche ein Freiraum zwischen benachbarten äußeren Rahmenteilen gebildet, der mit einem porösen Isolationsmaterial gefüllt ist. Das bedeutet insbesondere, dass der von radial außen zugängliche Freiraum zwischen benachbarten thermoelektrischen Materialien nicht (ausschließlich) mit Luft gefüllt ist, sondern dass hier (zusätzlich) ein poröses Isolationsmaterial vorgesehen ist. Das Material dient nun insbesondere dazu, eine elektrische Isolierung im Übergangsbereich zwischen benachbarten Halbleiterelementen zu realisieren. Ebenso kann das Isolationsmaterial dazu dienen, einen signifikanten Temperaturausgleich zwischen der Innenumfangsfläche und der Außenumfangsfläche im Bereich des Freiraums zu reduzieren oder zu verhindern. Die poröse Ausgestaltung des Isolationsmaterials führt insbesondere dazu, dass dieses sehr leicht ist und gleichwohl einen hohen Anteil von Luft als thermischen Isolator aufweisen kann. Als ein solches poröses Isolationsmaterial kommt insbesondere ein hochporöser Festkörper in Betracht, bei dem bspw. mindestens 95 % oder sogar mindestens 99 % des Volumens aus Poren besteht. Das Isolationsmaterial weist dabei bevorzugt eine stark dendritische Struktur auf, also eine Verästelung von Partikelketten mit sehr vielen Zwischenräumen in Form von offenen Poren, so dass insbesondere eine relativ stabile, schwammartige Netzstruktur gebildet ist. Ganz besonders bevorzugt ist hier der Einsatz eines sogenannten Aerogels, bspw. auf Basis eines Silikats. Erfindungsgemäß ist zumindest an der unterbrochenen Innenumfangsfläche oder an der unterbrochenen Außenumfangsfläche eine forminstabile Hülle vorgesehen. Die Anordnung einer solchen forminstabilen Hülle dient insbesondere dazu, unerwünschte Substanzen davon abzuhalten, in den Zwischenbereich zwischen den thermoelektrischen Materialien bzw. den Halbleiterelementen einzudringen. Eine solche forminstabile Hülle bietet sich insbesondere auf der Kaltseite des thermoelektrischen Moduls an. Gerade für diesen Einsatzzweck können Kunststofffolien, wie bspw. ein sogenannter Schrumpfschlauch, eingesetzt werden. So ist es bspw. möglich, das die Außenumfangsfläche umströmende Wasser mittels der forminstabilen Hülle davon abzuhalten, mit dem elektrischen Schaltkreis und/oder dem thermoelektrischen Material im thermoelektrischen Modul in Kontakt zu treten. Der Begriff "forminstabile" Hülle soll dabei insbesondere zum Ausdruck bringen, dass die Stabilität des thermoelektrischen Moduls nur in einem sehr geringen Umfang bzw. nur in einem vernachlässigbaren Umfang durch diese Hülle beeinflusst wird. Diese Stabilität soll über die Verbindungsbereiche der benachbarten Rahmenteile erreicht werden.

Diesbezüglich wird es als vorteilhaft angesehen, zwischen der forminstabilen Hülle und der Außenumfangsfläche und/oder der Innenumfangsfläche einen Kleber anzuordnen. Insbesondere wird dieser Kleber zwischen der forminstabilen Hülle und dem die Außenumfangsfläche bildenden äußeren Rahmenteil angeordnet. Somit kann an der sogenannten Kaltseite des thermoelektrischen Moduls ein entsprechender Kleber eingesetzt werden, der eine "geringe" Temperaturbeständigkeit von mindestens 150 °C, insbesondere mindestens 200 °C, aufweist. Dabei beträgt die maximale Temperaturbeständigkeit insbesondere 250 °C. Der Kleber ist insbesondere thermisch leitfähig, so dass der Wärmestrom über das thermoelektrische Modul nur in geringem Maße beeinflusst wird.

Darüber hinaus ist es möglich, dass in der unterbrochenen Innenumfangsfläche ein Spalt zwischen benachbarten inneren Rahmenteilen gebildet ist, der mit einer Dichtung überbrückt ist. In Anbetracht der Tatsache, dass bevorzugt ist, dass jeweils äußere Rahmenteile und jeweils innere Rahmenteile der benachbarten Halbleiterelemente miteinander verbunden sind, wird in Richtung der Achse gesehen wechselweise jeweils die Innenumfangsfläche und die Außenumfangsfläche unterbrochen. Im Bereich der Unterbrechung der Außenumfangsfläche wird hier von einem Freiraum gesprochen, wenn eine Unterbrechung im Bereich der Innenumfangsfläche vorliegt, von einem Spalt. Der Spalt betrifft dabei den Bereich des Zwischenraumes, der zwischen den gegenüberliegenden Stirnseiten der inneren Rahmenteile ausgebildet ist. Somit gilt für den Fall eines zylindrischen, rohrähnlichen thermoelektrischen Moduls, dass der Spalt eine im Wesentlichen zur Achse konzentrische Ringform aufweist. Je nach Ausprägung der gegenüberliegenden inneren Rahmenteile ist nun die Unterbrechung in der Innenumfangsfläche bzw. der Spalt unterschiedlich groß. Ist vorgesehen, dass die inneren Rahmenteile benachbarter Halbleiterelemente hier nicht über das thermoelektrische Material überstehen, so ist der Spalt im Wesentlichen so breit wie der Abstand der thermoelektrischen Materialien benachbarter Halbleiterelemente. Ist zumindest auf einer Seite eines Halbleiterelements das innere Rahmenteil hervorstehend ausgebildet, wird dieser Spalt kleiner. Insbesondere für den Fall, dass innerhalb der Innenumfangsfläche heißes Abgas durch das thermoelektrische Modul hindurchgeführt wird, soll nun verhindert werden, dass durch diesen Spalt (und in einen dahinter liegenden Freiraum hinein) Abgas eintritt und dort bspw. eine Temperaturangleichung zwischen der Innenumfangsfläche und der Außenumfangsfläche verursacht. Zu diesem Zweck ist folglich vorgesehen, dass der Spalt abgedichtet ist. Dazu kann ein entsprechendes Dichtmaterial zwischen dem inneren Rahmenteil des einen Halbleiterelements und dem inneren Rahmenteil des benachbarten Halbleiterelements positioniert sein. Die Anordnung der Dichtung ist dabei insbesondere so, dass auch bei (geringen) Relativbewegungen der inneren Rahmenteile zueinander und/oder bei einer ungleichen Ausprägung der Spalte gleichwohl unter allen Betriebsbedingungen eine praktisch gasdichte Verschließung des Spalts realisiert ist. Hierfür kann die Dichtung mit den inneren Rahmenteilen bspw. formschlüssig (formschlüssige Verbindungen entstehen durch das Ineinandergreifen von mindestens zwei Verbindungspartnern. Durch die mechanische Verbindung können sich die Verbindungspartner auch ohne oder bei unterbrochener Kraftübertragung nicht lösen.) und/oder beweglich ausgeführt sein. Die Dichtung ist dabei insbesondere geeignet, Temperaturen bis 400 °C oder sogar bis 700 °C zu widerstehen. Ebenso ist das Dichtmaterial bevorzugt so gestaltet, dass das thermische Ausdehnungsverhalten benachbarter Halbleiterelemente im Bereich des Spalts bzw. der Dichtung kompensiert werden kann.

Einer weiteren Ausgestaltung des thermoelektrischen Moduls zur Folge bilden die Halbleiterelemente im Bereich der unterbrochenen Innenumfangsfläche Aufnahmen für ein Dichtmaterial. Eine solche Aufnahme kann bspw. durch einen entsprechenden Freiraum gebildet sein, in dem Dichtmaterial teilweise oder vollständig angeordnet ist, bspw. durch Anlage an den äußeren Rahmenteilen, den thermoelektrischen Materialien sowie ggf. (teilweise) der inneren Rahmenteile. Ebenso ist möglich, dass das Dichtmaterial und die Rahmenteile einen Formschluss bilden, zum Beispiel nach Art einer Feder-Nut-Verbindung. Dieses Dichtmaterial hat insbesondere die Aufgabe, eine Ausbreitung von Abgas zwischen den thermoelektrischen Materialien zu behindern oder sogar zu verhindern, um hier ein Temperaturgefälle zwischen der Innenumfangsfläche und der Außenumfangsfläche auch während des Betriebs aufrecht zu erhalten. Das Dichtmaterial kann auch dazu dienen, eine elektrische Isolation darzustellen. Besonders bevorzugt ist der Einsatz von Glimmer (Aluminosilikat) oder einem vergleichbaren Material als Dichtmaterial.

Darüber hinaus wird als vorteilhaft angesehen, dass das thermoelektrische Material der Halbleiterelemente wenigstens teilweise mit einer Beschichtung versehen ist. Eine solche Beschichtung dient insbesondere dazu, dauerhaft die Zusammensetzung bzw. Konstitution des thermoelektrischen Materials zu gewährleisten. Die Beschichtung ist insbesondere vollflächig auf den Seitenfläche bzw. der Oberseite und/oder der Unterseite des thermoelektrischen Materials vorgesehen, so dass ganz besonders bevorzugt das thermoelektrische Material komplett eingefasst ist von einem inneren Rahmenteil, einem äußeren Rahmenteil und dieser Beschichtung.

Die Erfindung findet insbesondere Anwendungen bei Fahrzeugen, insbesondere Kraftfahrzeugen. Folglich wird ein Kraftfahrzeug mit einer Verbrennungskraftmaschine, einem Abgassystem und einem Kühlsystem vorgeschlagen, wobei ein thermoelektrischer Generator vorgesehen ist, der eine Mehrzahl der hier erfindungsgemäß beschriebenen Module aufweist, wobei sich das Abgassystem durch die Innenumfangsfläche des thermoelektrischen Moduls hindurch und das Kühlsystem außen entlang der Außenumfangsfläche des thermoelektrischen Moduls erstrecken. Das heißt mit anderen Worten auch, dass bspw. das Kühlmittel des Kühlmittelsystems außen entlang der Außenumfangsfläche der thermoelektrischen Module vorbeigeführt wird, so dass die Außenumfangsfläche des thermoelektrischen Moduls die Kaltseite darstellt. Ebenso bedeutet das, dass das heiße Abgas innen durch einen Kanal, der durch die Innenumfangsfläche der thermoelektrischen Module begrenzt ist, hindurchströmt, so dass die Innenumfangsfläche dann die Heißseite darstellt. Besonders bevorzugt ist, dass der thermoelektrische Generator dabei nach Art eines Rohrbündels aufgebaut ist, wobei einerseits eine Vielzahl dieser thermoelektrischen Module dann an das Abgassystems angeschlossen sind, so dass diese von heißem Abgas durchströmt werden, und andererseits die thermoelektrischen Module bspw. in einem gemeinsamen (beanstandeten) Gehäuse angeordnet sind, so dass diese gemeinsam von einem Kühlmittelstrom umströmt werden können. Selbstverständlich sind entsprechende elektrische Anschlüsse und Leitungen vorzusehen, um eine sichere Stromerzeugung und Weiterleitung des Stroms, des Kühlmittels und des Abgases zu realisieren.

Die Erfindung sowie der Stand der Technik werden nachfolgend anhand der Figuren näher erläutert. Es ist darauf hinzuweisen, dass die in den Figuren gezeigten Ausführungsbeispiele bevorzugt sind, die Erfindung jedoch nicht darauf beschränkt ist. Die Figuren zeigen schematisch:
- Fig. 1:: eine Anordnung mehrerer Halbleiterelemente zu einem thermoelektrischen Modul,
- Fig. 2:: einen Querschnitt durch eine Ausführungsvariante eines thermoelektrischen Moduls,
- Fig. 3:: einen Querschnitt durch eine weitere Ausführungsvariante eines Halbleiterelements,
- Fig. 4:: einen Querschnitt durch eine weitere Ausführungsvariante eines Halbleiterelements, und
- Fig. 5:: ein Schema für ein Fahrzeug mit einem thermoelektrischen Generator.

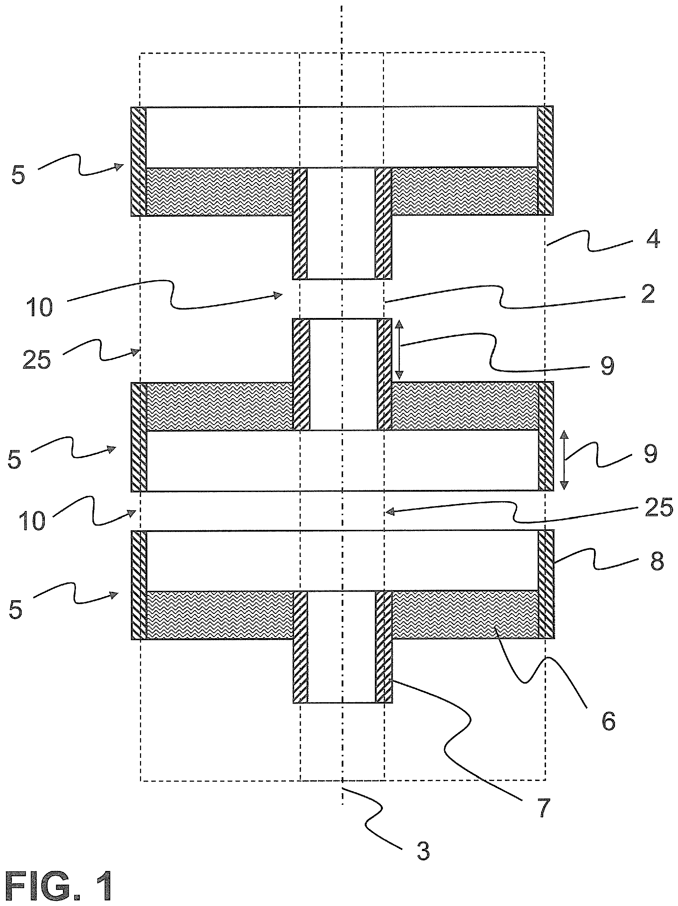

In Fig. 1 ist schematisch veranschaulicht, wie eine Mehrzahl von Halbleiterelementen 5 zusammengesetzt werden kann, um ein thermoelektrisches Modul mit den erfindungsgemäß angeführten Eigenschaften herzustellen. Zunächst ist hierbei festzuhalten, dass alle Halbleiterelemente 5 im Wesentlichen identisch ausgeführt sind, insbesondere was die Anordnung bzw. Abmaße des äußeren Rahmenteils 8, des thermoelektrischen Materials 6 und des inneren Rahmenteils 7 betrifft. Die entsprechende Verbindung bzw. der gewünschte Aufbau des thermoelektrischen Elements wird nun dadurch realisiert, dass die Halbleiterelemente 5 in Richtung der Achse 3 mit entgegen gesetzten Orientierungen abwechselnd zueinander angeordnet sind. Damit wird nun erreicht, dass die benachbarten Halbleiterelemente 5 entweder (nur) mit den inneren Rahmenteilen 7 oder den äußeren Rahmenteilen 8 miteinander beim Stapelvorgang in Kontakt kommen. Dabei ist ganz besonders bevorzugt, dass die thermoelektrischen Materialien 6 aller Halbleiterelemente 5, die in eine erste Richtung entlang der Achse 3 ausgerichtet sind, dieselbe Dotierung aufweisen (z. B. n-dotiert). Die jeweils dazwischen angeordneten, in eine zweite, entgegen gesetzte Richtung entlang der Achse 3 ausgerichteten Halbleiterelemente 5 weisen eine andere Dotierung auf (z. B. p-dotiert).

Bei der hier aufgezeigten Ausführungsvariante sind die Halbleiterelemente 5 nach Art von ringförmigen Scheiben ausgeführt, wobei insbesondere das thermoelektrische Material 6 nach Art einer Kreisringscheibe ausgeführt ist. Die radial innen liegende Umfangsfläche und außen liegende Umfangsfläche des thermoelektrischen Materials 6 ist jeweils von dem (einstückigen) äußeren Rahmenteil 8 bzw. dem (einstückigen) inneren Rahmenteil 7 bedeckt. Die Halbleiterelemente 5 sind weiter so gestaltet, dass die äußeren Rahmenteile 8 einen Überstand 9 auf einer Seite des thermoelektrischen Materials 6 ausbilden, während die inneren Rahmenteile 7 auf der gegenüberliegenden Seite einen Überstand 9 über das thermoelektrische Material 6 ausbilden. Diese Ausgestaltung zusammen mit der wechselweise entgegen gesetzten Orientierung dieser Überstände erlaubt es nun, dass benachbarte Halbleiterelemente 5 einerseits über die inneren Rahmenteile 7 Verbindungsbereiche 10 ausbilden sowie über benachbarte äußere Rahmenteile 8. Dabei bilden die Überstände 9 eine Art ringförmigen Kragen aus, die stirnseitig (auf Stoß) zusammengesetzt werden können. Dieser Stoßbereich dient insbesondere zur Ausbildung von stoffschlüssigen Verbindungen (stoffschlüssige Verbindungen werden Verbindungen genannt, bei denen die Verbindungspartner durch atomare und/oder molekulare Kräfte zusammengehalten werden, wie beispielsweise beim Kleben, Löten, Schweißen, etc.), insbesondere umlaufenden Schweißnähten.

Darüber hinaus ist bereits aus Fig. 1 zu erkennen, dass die so zusammengesetzten Halbleiterelemente 5 keine geschlossene Innenumfangsfläche 2 und keine geschlossene Außenumfangsfläche 4 bilden. Dies lässt sich insbesondere dadurch erkennen, dass in einem Querschnitt, in dem ein Verbindungsbereich 10 der inneren Rahmenteile 7 realisiert ist, außen kein äußeres Rahmenteil 8 vorgesehen ist und umgekehrt. Damit ist insbesondere auch gemeint, dass ein (einzelnes) äußeres Rahmenteil 8 nicht gleichzeitig mit beiden benachbarten äußeren Rahmenteilen 8 der benachbarten Halbleiterelemente 5 in Kontakt kommt. Ebenso gilt, dass ein (einzelnes) inneres Rahmenteil 7 eines Halbleiterelements 5 nicht mit beiden Rahmenteilen 7, 8 von benachbarten Halbleiterelementen 5 in Kontakt ist. Somit füllen die äußeren Rahmenteile 8 nicht vollständig die äußere (gedachte) Außenumfangsfläche 4 aus, ebenso füllen die inneren Rahmenteile 7 nicht die gesamte Innenumfangsfläche 2 aus. Vielmehr sind in beiden Fällen Unterbrechungen 25 gebildet. Hierbei wird insbesondere von der Vorstellung ausgegangen, dass sich die Innenumfangsfläche 2 und die Außenumfangsfläche 4 durch Umfangsflächenabschnitte beschreiben lässt, die im Wesentlichen dieselbe Distanz zur Achse 3 aufweisen. Handelt es sich bspw. um ein zylindrisches, rohrähnliches thermoelektrisches Modul, so sind die äußeren Rahmenteile 8 und die inneren Rahmenteile 7 bspw. ebenfalls zylindrisch gebildet, so dass folglich auch zylindrische Innenumfangsflächen 2 und Außenumfangsflächen 4 gebildet sind, die sich durch die jeweiligen äußeren Rahmenteile 8 und inneren Rahmenteile 7 hindurch erstrecken. Entsprechende Überlegungen können bspw. angestellt werden, wenn die Rahmenteile eine elliptische oder polygonale Umfangsfläche bilden, demnach hat das thermoelektrische Modul dann insgesamt auch eine elliptische oder polygonale Innenumfangsfläche/Außenumfangsfläche, in der jeweils die entsprechenden Umfangsabschnitte der äußeren Rahmenteile und inneren Rahmenteile aufgenommen sind. Erfindungsgemäß ist dann insbesondere, wenn die äußeren Rahmenteile 8 und inneren Rahmenteile 7 keine geschlossene, sondern eine unterbrochene, also nicht vollständig ausgefüllte, Innenumfangsfläche/Außenumfangsfläche bilden.

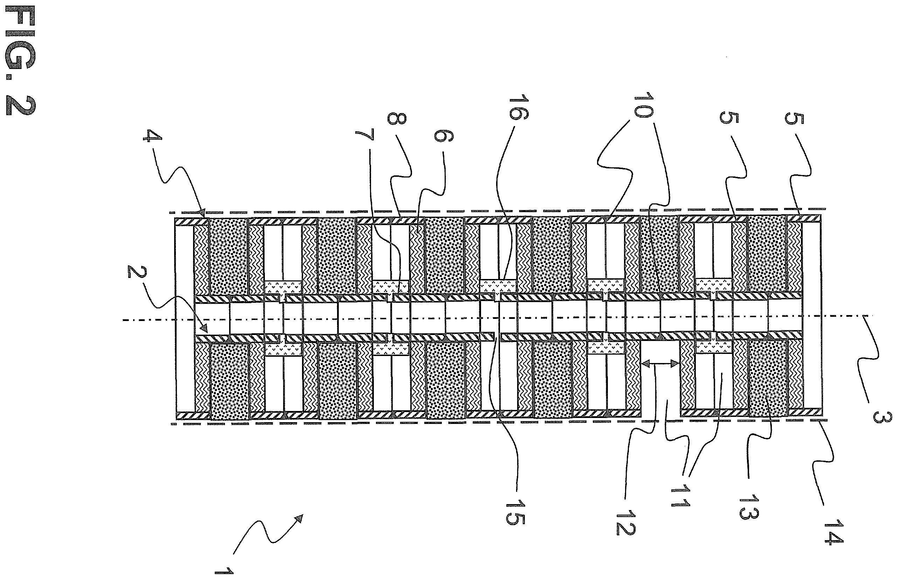

Fig. 2 zeigt nun eine zusammengesetzte Ausführungsvariante eines thermoelektrischen Moduls 1. Dabei sind nun die Halbleiterelemente 5 auf Stoß wechselweise entlang der Achse 3 angeordnet und miteinander befestigt. Die wechselweise Anordnung von Halbleiterelementen 5 erfolgt in der Art, dass die inneren Rahmenteile 7 aneinander anliegen und einen Verbindungsbereich 10 (z. B. eine Schweißnaht) ausbilden, so dass benachbart hierzu ein Freiraum 11 gebildet ist, der sich radial auswärts bis hin zur Außenumfangsfläche 4 erstreckt. Der Freiraum 11 ist nun so gestaltet, dass dieser einem Abstand 12 der thermoelektrischen Materialien 6 benachbarter Halbleiterelemente 5 entspricht. Zur Veranschaulichung wurde deshalb im oberen rechten Bereich der Fig. 2 ein Element (Isolationsmaterial 13) nicht dargestellt, das jedoch tatsächlich für den Betrieb vorgesehen ist.

Darüber hinaus ist hier zu erkennen, dass an der unterbrochenen Außenumfangsfläche 4 eine forminstabile Hülle 14 vorgesehen ist. Diese kann bspw. nach der Anordnung bzw. Präparation der innen liegenden Bauteile des thermoelektrischen Moduls 1 von außen über die Halbleiterelemente 5 übergestülpt werden. Hierfür bietet sich insbesondere eine Kunststofffolie an, bspw. ein sogenannter Schrumpfschlauch. Dieser Schrumpfschlauch bzw. diese forminstabile Hülle 14 gewährleistet nun, dass kein Wasser in Bereiche innerhalb der Außenumfangsfläche 4 eindringen kann. Gleichermaßen ist eine gute Wärmeleitung bzw. Kühlung hin zu den Halbleiterelementen 5 bzw. äußeren Rahmenteilen 8 gewährleistet. Hierfür ist die Hülle 14 entsprechend dünn auszuführen. Dabei kann zwischen der forminstabilen Hülle 14 und den äußeren Rahmenteilen 8 ein Kleber angeordnet werden, so dass insbesondere eine dichtende Verbindung zwischen äußeren Rahmenteilen 8 und der forminstabilen Hülle 14 erreicht wird. Insbesondere ist der Kleber nur an den jeweiligen Enden des thermoelektrischen Moduls 1 zwischen der forminstabilen Hülle 14 und den äußeren Rahmenteilen 8 angeordnet, so dass hier eine dichtende Verbindung gegenüber z. B. einem Kühlsystem erreicht wird.

Im Bereich dieser radial auswärts offenen Freiräume 11 ist nun zudem ein poröses Isolationsmaterial 13 vorgesehen. Hierbei handelt es sich insbesondere um ein sogenanntes Aerogel. Dadurch ist einerseits der gewünscht große Temperaturgradient und zum anderen die elektrische Neutralität des Freiraums 11 gewährleistet. Hierbei ist bevorzugt, dass das poröse Isolationsmaterial 13 den gesamten sich nach außen öffnenden Freiraum 11 ausfüllt.

Im mittleren Bereich der Fig. 2 ist zudem ebenfalls unter Weglassung eines Elements (Dichtung 16) die Situation an der unterbrochenen Innenumfangsfläche 2 veranschaulicht. Dort sind benachbarte Halbleiterelemente 5, die über hervorstehende, zueinander hin ausgerichtete äußere Rahmenteile 8 verbunden sind, ebenso mit hervorstehenden inneren Rahmenteilen 7 ausgeführt, wobei diese nicht in Kontakt miteinander sind, sondern zwischen sich einen Spalt 15 ausbilden. In diesen Spalt 15 hinein erstreckt sich nunmehr eine Dichtung 16, die auch teilweise in dem Freiraum 11 angeordnet ist, der sich zwischen den mit einem Spalt 15 beabstandeten inneren Rahmenteilen 7 und den über einen Verbindungsbereich 10 miteinander verbundenen äußeren Rahmenteilen 8 erstreckt. Hierbei ist ganz besonders bevorzugt, dass die Dichtung 16 sich im Wesentlichen nur zwischen den benachbarten inneren Rahmenteilen 7 befindet, also folglich insbesondere ein Volumen hat, das nicht größer als das 5-fache des Spalts 15 ist.

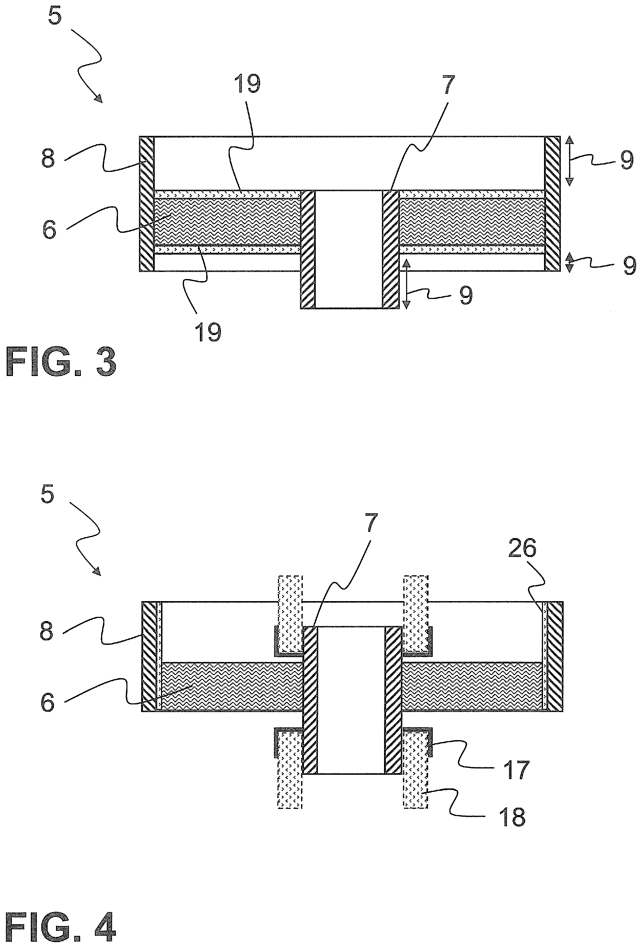

Fig. 3 zeigt den Querschnitt einer Ausführungsvariante eines Halbleiterelements 5 für ein solches thermoelektrisches Modul. Hierbei ist das Halbleiterelement 5 bspw. zylindrisch, viereckig oder oval ausgeführt. Bei der hier vorgestellten Ausführungsvariante ist wieder ein im Wesentlichen ringförmig ausgebildetes thermoelektrisches Material 6 vorgesehen, das bspw. aus gepresstem Pulver besteht. Ebenso ist bevorzugt, dass dieses thermoelektrische Material 6 durch Pressen kraftschlüssig (und/oder stoffschlüssig) mit dem inneren Rahmenteil 7 und/oder dem äußeren Rahmenteil 8 verbunden ist. Hierbei ist nun vorgesehen, dass nach oben hin ein großer Überstand 9 mit dem äußeren Rahmenteil 8 und nach unten ein kleiner Überstand 9 mit dem äußeren Rahmenteil 8 und ein großer Überstand 9 mit dem inneren Rahmenteil 7 ausgebildet ist. Auf diese Weise können die Kontaktbereiche bzw. Freiräume hin zu benachbarten Halbleiterelementen bei der Anordnung zu einem thermoelektrischen Modul wunschgemäß ausgebildet werden. Zum Schutz des thermoelektrischen Materials 6, z. B. vor einer chemischen Beanspruchung, vor einer thermischen Beanspruchung und/oder vor einer Beschädigung, weist das thermoelektrische Material 6 an den Grenzflächen, an denen es nicht mit dem inneren Rahmenteil 7 oder dem äußeren Rahmenteil 8 bedeckt ist, eine Beschichtung 19 auf. Die Beschichtung 19 hat dabei eine Dicke, die mindestens um ein Vielfaches kleiner ausgeführt ist als die Wandstärke des äußeren Rahmenteils, des inneren Rahmenteils und/oder des thermoelektrischen Materials 6 selbst. Als Material für diese Beschichtung 19 kommt beispielsweise eine Nickel oder Molybdän aufweisende, insbesondere aus diesen Materialien nahezu vollständig bestehende Beschichtung 19 in Betracht. Die Beschichtung 19 dient hierbei als Diffusionssperre für das thermoelektrische Material 6.

Fig. 4 zeigt eine weitere Ausführungsvariante des Halbleiterelements, wobei hier mit dem inneren Rahmenteil 7 Aufnahmen 17 für ein Dichtmaterial 18 ausgebildet sind. Diese können ebenfalls als eine Art umlaufender Kragen, als Nut oder ein ähnlich geeignetes Formelement ausgebildet sein. Zudem ist möglich, dass die Aufnahmen 17 einstückig mit dem inneren Rahmenteil 7 ausgebildet sind. Das angedeutete Dichtmaterial 18 dient insbesondere zum Abdichten eines Spalts zwischen benachbarten inneren Rahmenteilen 7. Ebenso ist hier eine Isolationsschicht 26 veranschaulicht.

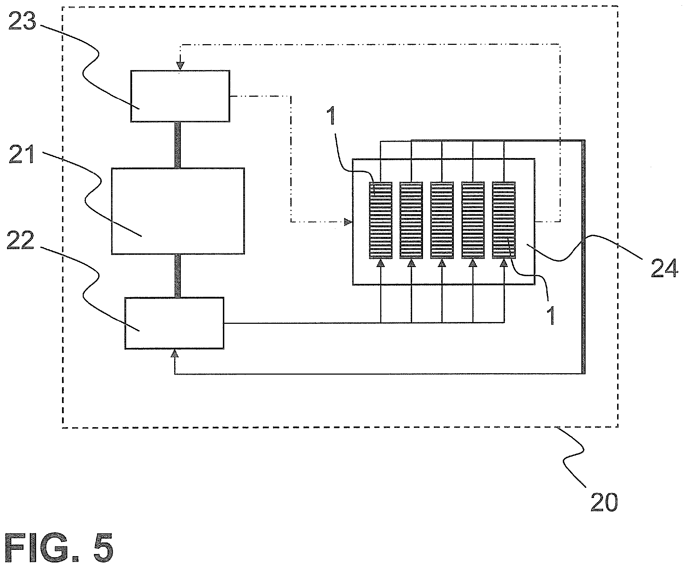

Schließlich ist in Fig. 5 schematisch noch der Aufbau eines Fahrzeugs 20 veranschaulicht, das eine Verbrennungskraftmaschine 21, ein Abgassystem 22 und ein Kühlsystem 23 hat. Zudem weist das Fahrzeug 20 einen thermoelektrischen Generator 24 auf, der in eine Mehrzahl der hier erfindungsgemäß vorgestellten thermoelektrischen Module 1 aufweist. Der thermoelektrische Generator 24 ist so mit dem Abgassystem 22 und dem Kühlsystem 23 ausgebildet, dass auf der Außenumfangsfläche 4 der Module 1 die Kaltseite und auf der Innenumfangsfläche 2 des thermoelektrischen Moduls 1 die Heißseite realisiert ist. Dazu wird zumindest ein Teil des Abgases durch die einzelnen thermoelektrischen Module 1 hindurchgeführt, bevor sie dem Abgassystem 22 (oder der Verbrennungskraftmaschine 21) wieder zugeführt werden. Zur Ausbildung des erforderlichen Temperaturprofils hinsichtlich der thermoelektrischen Module 1 wird zudem Kühlmittel mittels des Kühlmittelsystems 23 so zu dem thermoelektrischen Generator 24 geführt, dass das Kühlmittel außen die thermoelektrischen Module 1 umströmt und schließlich dem Kühlsystem 23 (oder der Verbrennungskraftmaschine 21) zugeführt wird. Selbstverständlich ist möglich, dass das Kühlsystem 23 und/oder das Abgassystem 22 mit Sekundär-Schaltkreisen für Abgas und/oder Kühlmittel ausgeführt sind. Ebenso ist möglich, dass bspw. in dem Abgassystem zusätzliche Wärmetauscher, Klappen, Katalysatoren, etc. vorgesehen sind. Ebenso ist offensichtlich, dass der thermoelektrische Generator 24 auch elektrisch mit dem Fahrzeug 20 in Verbindung steht, bspw. über geeignete Stromabnehmer, Stromspeicher, Steuerungen, etc.

Damit löst die Erfindung die mit Bezug auf den Stand der Technik geschilderten Probleme zumindest teilweise. Insbesondere wurde ein thermoelektrisches Modul angegeben, das technisch einfach herstellbar ist, eine reduzierte Teilezahl aufweist, für den gewünschten Einsatz stabil ist und zudem einen hohen Wirkungsgrad aufweist, um mit der thermischen Energie eines Abgases elektrische Energie zu erzeugen.

### Bezugszeichenliste

- 1: thermoelektrisches Modul
- 2: Innenumfangsfläche
- 3: Achse
- 4: Außenumfangsfläche
- 5: Halbleiterelement
- 6: thermoelektrisches Material
- 7: inneres Rahmenteil
- 8: äußeres Rahmenteil
- 9: Überstand
- 10: Verbindungsbereich
- 11: Freiraum
- 12: Abstand
- 13: Isolationsmaterial
- 14: Hülle
- 15: Spalt
- 16: Dichtung
- 17: Aufnahme
- 18: Dichtmaterial
- 19: Beschichtung
- 20: Fahrzeug
- 21: Verbrennungskraftmaschine
- 22: Abgassystem
- 2 3: Kühlsystem
- 24: thermoelektrischer Generator
- 2 5: Unterbrechung
- 26: Isolationsschicht

## Patentansprüche

1. Thermoelektrisches Modul (1), aufweisend eine Innenumfangsfläche (2), eine Achse (3) und eine Außenumfangsfläche (4), wobei in Richtung der Achse (3) und zwischen der Innenumfangsfläche (2) und der Außenumfangsfläche (4) eine Mehrzahl von Halbleiterelementen (5) mit thermoelektrischem Material (6) angeordnet und elektrisch miteinander wechselweise verbunden sind, wobei wenigstens ein Teil der Halbleiterelemente (5) zumindest ein inneres Rahmenteil (7) oder ein äußeres Rahmenteil (8) aufweist, und zumindest innere Rahmenteile (7) eine unterbrochene Innenumfangsfläche (2) oder äußere Rahmenteile (8) eine unterbrochene Außenumfangsfläche (4) bilden, **dadurch gekennzeichnet, dass** zumindest an der unterbrochenen Innenumfangsfläche (2) oder an der unterbrochenen Außenumfangsfläche (4) eine forminstabile Hülle (14) vorgesehen ist..

2. Thermoelektrisches Modul (1) nach Patentanspruch 1, bei dem Halbleiterelemente (5) thermoelektrisches Material (6) umfassen, das zwischen einem inneren Rahmenteil (7) und einem äußeren Rahmenteil (8) angeordnet ist, wobei das innere Rahmenteil (7) und das äußere Rahmenteil (8) jeweils einseitig über das thermoelektrische Material (6) überstehen und dort einen formsteifen Verbindungsbereich (10) mit einem benachbarten Rahmenteil bilden.

3. Thermoelektrisches Modul (1) nach Patentanspruch 1 oder 2, wobei zumindest das innere Rahmenteil (7) oder das äußere Rahmenteil (8) eine Isolationsschicht (26) aufweist.

4. Thermoelektrisches Modul (1) nach einem der vorhergehenden Patentansprüche, bei dem in der unterbrochenen Außenumfangsfläche (4) ein Freiraum (11) zwischen benachbarten äußeren Rahmenteilen (8) gebildet ist, der einem Abstand (12) des thermoelektrischen Materials (6) benachbarter Halbleiterelemente (5) entspricht.

5. Thermoelektrisches Modul (1) nach einem der vorhergehenden Patentansprüche, bei dem zumindest in der unterbrochenen Außenumfangsfläche (4) ein Freiraum (11) zwischen benachbarten äußeren Rahmenteilen (8) gebildet ist, der mit einem porösen Isolationsmaterial (13) gefüllt ist.

6. Thermoelektrisches Modul (1) nach einem der vorhergehenden Patentansprüche, bei dem zwischen der forminstabilen Hülle (14) und der Außenumfangsfläche (4) und/oder der Innenumfangsfläche (2) ein Kleber angeordnet ist.

7. Thermoelektrisches Modul (1) nach einem der vorhergehenden Patentansprüche, bei dem in der unterbrochenen Innenumfangsfläche (2) ein Spalt (15) zwischen benachbarten inneren Rahmenteilen (7) gebildet ist, der mit einer Dichtung (16) überbrückt ist.

8. Thermoelektrisches Modul (1) nach einem der vorhergehenden Patentansprüche, bei dem die Halbleiterelemente (5) im Bereich der unterbrochenen Innenumfangsfläche (2) Aufnahmen (17) für ein Dichtmaterial (18) bilden.

9. Thermoelektrisches Modul (1) nach einem der vorhergehenden Patentansprüche, bei dem das thermoelektrische Material (6) der Halbleiterelemente (5) wenigstens teilweise mit einer Beschichtung (19) versehen ist.

10. Fahrzeug (20) mit einer Verbrennungskraftmaschine (21), einem Abgassystem (22) und einem Kühlsystem (23), wobei ein thermoelektrischer Generator (24) vorgesehen ist, der eine Mehrzahl von thermoelektrischen Modulen (1) gemäß einem der vorhergehenden Patentansprüche aufweist, wobei sich das Abgassystem (22) durch die Innenumfangsfläche (2) des thermoelektrischen Moduls (1) hindurch und das Kühlsystem (23) außen entlang der Außenumfangsfläche (4) des thermoelektrischen Moduls (1) erstrecken.

## Claims

1. Thermoelectric module (1) including an inner circumferential surface (2), an axis (3), and an outer circumferential surface (4), wherein a multitude of semiconductor elements (5) with a thermoelectric material (6) is arranged in a direction of the axis (3) and in between the inner circumferential surface (2) and the outer circumferential surface (4) and is connected to each other in an alternating manner, wherein at least a part of the semiconductor elements (5) includes at least an inner frame part (7) or an outer frame part (8), and wherein at least inner frame parts (7) form an interrupted inner circumferential surface (2) or outer frame parts (8) form an interrupted outer circumferential surface (4), **characterized in that** an inherently unstable shell (14) is provided at least at the interrupted inner circumferential surface (2) or at the interrupted outer circumferential surface (4).

2. Thermoelectric module (1) according to claim 1, wherein semiconductor elements (5) include thermoelectric material (6), which is arranged in between an inner frame part (7) and an outer frame part (8), wherein the inner frame part (7) and the outer frame part (8) each protrude over the thermoelectric material (6) on one side and, at that site, form a connection section (10) with a neighboring frame part.

3. Thermoelectric module (1) according to claims 1 or 2, wherein at least the inner frame part (7) or the outer frame part (8) include an isolation layer (26).

4. Thermoelectric module (1) according to any of the preceding claims, wherein in the interrupted outer circumferential surface (4) an open space (11) is formed between neighboring outer frame parts (8), the open space (11) corresponding to a distance (12) of the thermoelectric material (6) of neighboring semiconductor elements (5).

5. Thermoelectric module (1) according to any of the preceding claims, wherein an open space (11) is formed between neighboring outer frame parts (8) at least at the interrupted outer circumferential surface (4), the open space (11) being filled with a porous isolation material (13).

6. Thermoelectric module (1) according to any of the preceding claims, wherein an adhesive is arranged in between the inherently unstable shell (14) and the outer circumferential surface (4) and/or the inner circumferential surface (2).

7. Thermoelectric module (1) according to any of the preceding claims, wherein a gap (15) is formed at the interrupted inner circumferential surface (2) in between neighboring inner frame parts (7), the gap (15) being bridged by a sealing (16).

8. Thermoelectric module (1) according to any of the preceding claims, wherein the semiconductor elements (5) form seatings (17) for a sealing material (18) in the region of the interrupted inner circumferential surface (2).

9. Thermoelectric module (1) according to any of the preceding claims, wherein the thermoelectric material (6) of the semiconductor elements (5) is equipped at least partly with a coating (19).

10. Vehicle (20) with a combustion engine (21), an exhaust gas system (22) and a cooling system (23), wherein a thermoelectric generator (24) is provided, which has a multitude of thermoelectric modules (1) according to any of the preceding claims, wherein the exhaust gas system (22) extends through the inner circumferential surface (2) of the thermoelectric module (1) and the cooling system (23) extends externally along the outer circumferential surface (4) of the thermoelectric module (1).

## Revendications

1. Module thermoélectrique (1) présentant une surface périphérique intérieure (2), un axe (3) et une surface périphérique extérieure (4),
plusieurs éléments semi-conducteurs (5) dotés d'un matériau thermoélectrique (6) étant disposés dans la direction de l'axe (3) entre la surface périphérique intérieure (2) et la surface périphérique extérieure (4) et étant reliés en alternance les uns aux autres,
au moins une partie des éléments semi-conducteurs (5) présentant au moins une partie intérieure de cadre (7) ou une partie extérieure de cadre (8) et au moins les parties intérieures de cadre (7) formant une surface périphérique intérieure (2) interrompue ou des parties de cadre extérieur (8) formant une surface périphérique extérieure (4) interrompue,
**caractérisé en ce que**
une enveloppe (14) de forme instable est prévue au moins sur la surface périphérique intérieure interrompue (2) ou sur la surface périphérique extérieure interrompue (4).

2. Module thermoélectrique (1) selon la revendication 1, dans lequel des éléments semi-conducteurs (5) comprennent un matériau thermoélectrique (6) disposé entre une partie intérieure de cadre (7) et une partie extérieure de cadre (8), la partie intérieure de cadre (7) et la partie extérieure de cadre (8) débordant chacune d'un côté au-delà du matériau thermoélectrique (6) pour y former une zone de liaison (10) de forme rigide avec une partie de cadre voisine.

3. Module thermoélectrique (1) selon les revendications 1 ou 2, dans lequel au moins la partie intérieure de cadre (7) ou la partie extérieure de cadre (8) présentent une couche d'isolation (26).

4. Module thermoélectrique (1) selon l'une des revendications précédentes, dans lequel un espace libre (11) est formé dans la surface périphérique extérieure (4) interrompue entre des parties extérieures de cadre (8) voisines, et correspond à une distance (12) entre le matériau thermoélectrique (6) d'éléments semi-conducteurs voisins (5).

5. Module thermoélectrique (1) selon l'une des revendications précédentes, en ce qu'un espace libre (11) est formé entre des parties extérieures de cadre (8) voisines au moins dans la surface périphérique extérieure interrompue (4) et est rempli d'un matériau d'isolation poreux (13).

6. Module thermoélectrique (1) selon l'une des revendications précédentes, dans lequel un adhésif est disposé entre l'enveloppe (14) de forme instable et la surface périphérique extérieure (4) et/ou la surface périphérique intérieure (2).

7. Module thermoélectrique (1) selon l'une des revendications précédentes, dans lequel un interstice (15) qui est rempli d'un joint d'étanchéité (16) est formé entre des parties intérieures de cadre (7) voisines dans la surface périphérique intérieure (2) interrompue.

8. Module thermoélectrique (1) selon l'une des revendications précédentes, dans lequel les éléments semi-conducteurs (5) forment au niveau de la surface périphérique intérieure (2) interrompue des logements (17) pour un matériau d'étanchéité (18).

9. Module thermoélectrique (1) selon l'une des revendications précédentes, dans lequel le matériau thermoélectrique (6) des éléments semi-conducteurs (5) est doté au moins en partie d'un revêtement (19).

10. Véhicule (20) doté d'un moteur (21) à combustion interne, d'un système (22) de gaz d'échappement et d'un système de refroidissement (23), un générateur thermoélectrique (24) qui présente plusieurs modules thermoélectriques (1) selon l'une des revendications précédentes étant prévus, le système (22) de gaz d'échappement s'étendant à travers la surface périphérique intérieure (2) du module thermoélectrique (1) et le système de refroidissement (23) s'étendant à l'extérieur le long de la surface périphérique extérieure (4) du module thermoélectrique (1).
